# EUROPEAN PATENT APPLICATION

(11) **EP 4 376 300 A1**
(43) Date of publication of application: **29.05.2024**
(21) Application number: 22208812.2
(22) Date of filing: 22.11.2022
(51) Int. Cl.: H03K 17/12, H03K 17/16

(54) **A GATE DRIVER CIRCUIT**

(71) Applicant: NXP USA, Inc., Austin TX 78735 (US)
(72) Inventor: KANDAH, Ibrahim Shihadeh, Austin, 78735 (US); RUDIAK, Jerry, Austin, 78735 (US); EVERSON, Steven Ray, Austin, 78735 (US)
(74) Representative: Schmütz, Christian Klaus Johannes

(57) **Abstract**

A gate driver circuit for driving the gate of a power device. The gate driver circuit comprises: a gate monitoring terminal, which is connectable to the gate of the power device such that a gate voltage signal is receivable at the gate monitoring terminal; a first comparator configured to compare the gate voltage signal with a first threshold value to provide a first gate monitor signal; a second comparator configured to compare the gate voltage signal with a second threshold value, which is different to the first threshold value, to provide a second gate monitor signal; and a controller. The controller is configured to: determine a gate slew rate based on the period of time between the first gate monitor signal and the second gate monitor signal changing value for a transition in the gate voltage signal; compare the gate slew rate with a slew rate threshold; and provide an output signal based on the result of the comparison between the gate slew rate with the slew rate threshold.

## Description

### Field

The present disclosure relates to gate driver circuits for driving the gate of a field effect transistor, FET, and in particular to driving a FET that is implemented as a plurality of FETs in parallel with each other. The present disclosure also relates to inverter circuits that include such gate driver circuits.

### Summary

According to a first aspect of the present disclosure there is provided a gate driver circuit for driving the gate of a power device, wherein the gate driver circuit comprises:
a gate monitoring terminal, which is connectable to the gate of the power device such that a gate voltage signal is receivable at the gate monitoring terminal;
a first comparator configured to compare the gate voltage signal with a first threshold value to provide a first gate monitor signal;
a second comparator configured to compare the gate voltage signal with a second threshold value, which is different to the first threshold value, to provide a second gate monitor signal;
a controller configured to:
   determine a gate slew rate based on the period of time between the first gate monitor signal and the second gate monitor signal changing value for a transition in the gate voltage signal;
   compare the gate slew rate with a slew rate threshold; and
   provide an output signal based on the result of the comparison between the gate slew rate with the slew rate threshold.

In one or more embodiments, the power device comprises a field effect transistor, an insulated-gate bipolar transistor, or a silicon carbide field effect transistor.

In one or more embodiments:
the first comparator is configured to compare the gate voltage signal with a negative threshold value to provide a gate monitor low signal; and / or
the second comparator configured to compare the gate voltage signal with a positive threshold value to provide a gate monitor high signal.

In one or more embodiments, the controller is configured to:
provide an output signal that is indicative of a fault if the difference between the gate slew rate and the slew rate threshold is greater than a predetermined level.

In one or more embodiments, the gate slew rate threshold is based on a determined gate slew rate for a previous transition in the gate voltage signal.

In one or more embodiments, the slew rate threshold is based on a determined gate slew rate for the immediately previous transition in the gate voltage signal.

In one or more embodiments, the gate slew rate threshold is based on: a determined gate slew rate for a previous transition in the gate voltage signal plus or minus an offset value.

In one or more embodiments, the controller is further configured to:
store the determined gate slew rate in memory for use as at least a component of a slew rate threshold for a future transition in the gate voltage signal.

In one or more embodiments:
the controller is configured to receive a drive strength signal that represents a requested drive strength for the gate of the power device; and
the gate slew rate threshold is based on a determined gate slew rate for a previous transition in the gate voltage signal for the same value of the requested drive strength.

In one or more embodiments:
the controller is configured to receive a drive strength signal that represents a requested drive strength for the gate of the power device; and
the gate slew rate threshold is based on a determined gate slew rate for the immediately previous transition in the gate voltage signal only if the immediately previous transition in the gate voltage signal was for operation with the same value of the requested drive strength.

In one or more embodiments, the controller is configured to:
receive a drive strength signal that represents a requested drive strength for the gate of the power device; and
set the slew rate threshold as one of a plurality of predetermined values based on the received drive strength signal.

In one or more embodiments: the gate slew rate threshold is based on: a predetermined gate slew rate for the requested drive strength plus or minus an offset value.

In one or more embodiments, the controller is configured to: determine the gate slew rate based on the period of time between the first gate monitor signal and the second gate monitor signal changing value for a positive transition in the gate voltage signal.

In one or more embodiments, the controller is configured to: determine the gate slew rate based on the period of time between the first gate monitor signal and the second gate monitor signal changing value for a negative transition in the gate voltage signal.

In one or more embodiments, the power device comprises a plurality of paralleled-power devices.

There is also disclosed an inverter circuit comprising:
a motor that is operable in accordance with a control signal;
a high-side power device having a conduction channel that is connected in series between a positive voltage supply and a control signal terminal;
a low-side power device having a conduction channel that is connected in series between the control signal terminal and a negative voltage supply;
a high-side gate driver circuit that comprises any gate driver circuit disclosed herein, wherein the high-side gate driver circuit is for driving the gate of the high-side power device;
a low-side gate driver circuit that comprises any gate driver circuit disclosed herein, wherein the low-side gate driver circuit is for driving the gate of the low-side power device; and
wherein:
   the voltage at the control signal terminal is connected to the motor in order to provide the control signal to the motor when the inverter circuit is in use;
   the slew rate threshold for the high-side gate driver circuit is based on a determined gate slew rate for the low-side gate driver circuit; and / or
   the slew rate threshold for the low-side gate driver circuit is based on a determined gate slew rate for the high-side gate driver circuit.

In one or more embodiments, the controller of the high-side gate driver circuit and / or the low-side gate driver circuit is configured to:
determine the gate slew rate based on the period of time between the first gate monitor signal and the second gate monitor signal changing value for a negative transition in the gate voltage signal of the associated power device; and
provide an output signal to the other one of the high-side gate driver circuit and the low-side gate driver circuit based on the result of the comparison of the gate slew rate with the slew rate threshold, wherein the output signal is for setting a time at which the power device associated with the other one of the high-side gate driver circuit and the low-side gate driver circuit is switched on.

In one or more embodiments, the controller of the high-side gate driver circuit and / or the low-side gate driver circuit is configured to:
determine the gate slew rate based on the period of time between the first gate monitor signal and the second gate monitor signal changing value for a negative transition in the gate voltage signal;
set a slew rate first threshold and / or a slew rate second threshold based on a deadtime that is applied by the controller;
compare the gate slew rate with a slew rate first threshold and / or a slew rate second threshold; and
set the deadtime that is applied by the controller based on the result of the comparison.

There is also disclosed an inverter circuit comprising:
a three-phase motor that is operable in accordance with a first-phase control signal, a second-phase control signal and a third-phase control signal;
a first-phase high-side power device having a conduction channel that is connected in series between a positive voltage supply and a first-phase control signal terminal;
a first-phase low-side power device having a conduction channel that is connected in series between the first-phase control signal terminal and a negative voltage supply;
a second-phase high-side power device having a conduction channel that is connected in series between the positive voltage supply and a second-phase control signal terminal;
a second-phase low-side power device having a conduction channel that is connected in series between the second-phase control signal terminal and the negative voltage supply;
a third-phase high-side power device having a conduction channel that is connected in series between the positive voltage supply and a third-phase control signal terminal;
a third-phase low-side power device having a conduction channel that is connected in series between the third-phase control signal terminal and the negative voltage supply;
a plurality of gate driver circuits that each comprise any gate driver circuit disclosed herein, one for each of the six power devices, wherein the slew rate threshold for each of the gate driver circuits is based on a determined gate slew rate for one or more of the other gate driver circuits.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of an inverter circuit according to the present disclosure;
Figure 2 shows an example timing diagram for driving a high-side FET and a low-side FET of any of the legs of Figure 1;
Figure 3 shows an example embodiment of a gate driver circuit for driving the gate of a FET;
Figure 4 shows some example timing diagrams for the gate driver circuit of Figure 3;
Figure 5 shows a method of operating a gate driver circuit according to an example embodiment of the present disclosure; and
Figure 6 shows some additional example timing diagrams for the gate driver circuit of Figure 3.

### Detailed Description

The present disclosure relates to the utilization of measuring the change in the gate charge and discharge times for the purpose of detecting either unwanted changes or expected changes in the charge profile at the control terminal of a power device, such as the gate of a FET. This can include changes to the series gate sourcing resistance (Rg + Rdson of the pre-drivers) or changes in the gate capacitance (loss of an internal power device gate). It could also be used to incrementally detect a change in the gate charge profile, such as would occur as a result of switched load current. In any case, the basic concept is to measure the gate transition time and utilize it as a diagnostic tool to determine drive and system health.

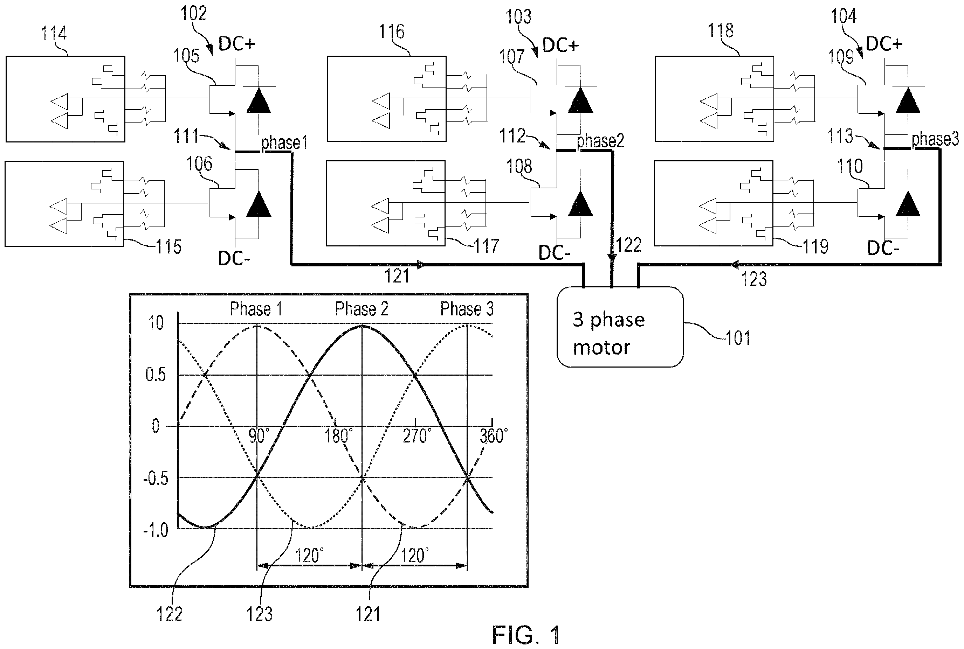

Figure 1 shows an example embodiment of an inverter circuit according to the present disclosure.

The inverter circuit includes a three-phase motor 101 that is operable in accordance with a first-phase control signal 121, a second-phase control signal 122 and a third-phase control signal 123, as is known in the art. An example timing diagram of the first-phase control signal 121, the second-phase control signal 122 and the third-phase control signal 123 is shown in Figure 1.

Figure 1 also shows a three-phase inverter that provides the control signals to the three-phase motor 101. The three-phase inverter includes: a first leg 102, which provides the first-phase control signal 121; a second leg 103 that provides the second-phase control signal 122; and a third leg 104 that provides the third-phase control signal 123.

The first leg 102 includes a first-phase high-side FET (field effect transistor) 105, which has a conduction channel (between its drain and its source) that is connected in series between a positive voltage supply (DC+) and a first-phase control signal terminal 111. The first leg also includes a first-phase low-side FET 106, which has a conduction channel that is connected in series between the first-phase control signal terminal 111 and a negative voltage supply (DC-). The voltage at the first-phase control signal terminal 111 represents the first-phase control signal 121 that is provided to the three-phase motor 101.

The second leg 103 includes a second-phase high-side FET 107 having a conduction channel that is connected in series between the positive voltage supply (DC+) and a second-phase control signal terminal 112. The second leg 103 also includes a second-phase low-side FET 108, which has a conduction channel that is connected in series between the second-phase control signal terminal 112 and the negative voltage supply (DC-). The voltage at the second-phase control signal terminal 112 represents the second-phase control signal 122 that is provided to the three-phase motor 101.

The third leg 104 includes a third-phase high-side FET 109, which has a conduction channel that is connected in series between the positive voltage supply (DC+) and a third-phase control signal terminal 113. The third leg 104 also includes a third-phase low-side FET 110, which has a conduction channel that is connected in series between the third-phase control signal terminal 113 and the negative voltage supply (DC-). The voltage at the third-phase control signal terminal 113 represents the third-phase control signal 123 that is provided to the three-phase motor 101.

Each of the six FETs 105, 106, 107, 108, 109, 110 has an associated gate driver circuit 114, 115, 116, 117, 118, 119 for driving the gate (i.e. providing a current signal to the gate) of a respective one of the FETs. As will be discussed in detail below, a gate driving circuit can drive the gate of a FET with a positive current to switch the FET on such that it's conduction channel is electrically conductive, or a gate driving circuit can drive the gate of a FET with a negative current to switch the FET off such that it's conduction channel is not electrically conductive. Furthermore, the FETs are driven with pulse width modulated (PWM) signals in this example to drive the three-phase motor 101 as is known in the art. The PWM frequency of each phase can be in excess of 10 times faster than the fundamental phase current frequency.

In other examples, different types of power devices can be used instead of the FETs that are shown in Figure 1. Such types of power devices include IGBTs (insulated-gate bipolar transistor) or other sub-types of FET such as SiC (silicon carbide). It will be appreciated that this also applies for the other FETs that are disclosed in this document.

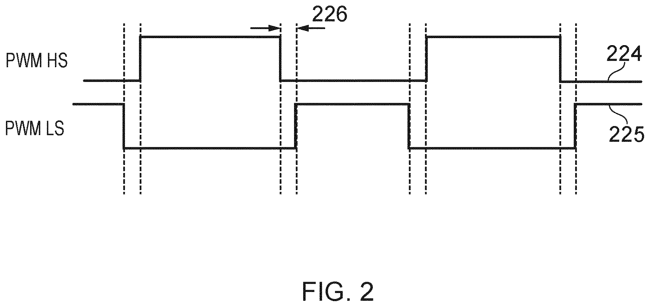

Figure 2 shows an example timing diagram for driving a high-side FET and a low-side FET of any of the legs of Figure 1.

A first signal 224 is shown that is labelled as PWM HS. The first signal 224 is a pulse width modulation signal that is used to drive a high-side FET. A second signal 225 is shown that is labelled as PWM LS. The second signal 225 is a pulse width modulation signal that is used to drive a low-side FET.

When a high-set FET is closed (when the first signal 224 is high), a positive voltage is provided at the associated control signal terminal (as shown in Figure 1). When a low-set FET is closed (when the second signal 225 is high), a negative voltage is provided at the associated control signal terminal. As will be appreciated from the timing diagram that is shown in Figure 1, the control signals that are provided at each of the control signal terminals of the three legs are 120° out of phase with each other.

Figure 2 also shows that there is a deadtime 226 between high-side and low-side power switch activation for a given phase. During this deadtime 226, both the high-side FET and the low-side FET are off. It is generally desired to have at least a minimum value of the deadtime 226 to reduce the likelihood of unwanted shoot through currents (which will not necessarily generate short circuit faults but can result in reduced efficiency of the inverter). Also, it is generally desired to have as short a deadtime as possible to avoid the unwanted shoot through currents.

Each of the FETs 105, 106, 107, 108, 109, 110 that are shown in Figure 1, which can also be referred to as switching power devices, can be implemented as a plurality of FETs in parallel with each other. Each of these plurality of FETs will be described as a paralleled-FET in this document. If one or more of these paralleled-FETs / devices have their gate disconnected due to a fault, the remaining paralleled-FETs / devices will operate at increased current density.

This can create potential heating and reliability issues. Examples disclosed herein can detect such a fault such that it can be identified to a user.

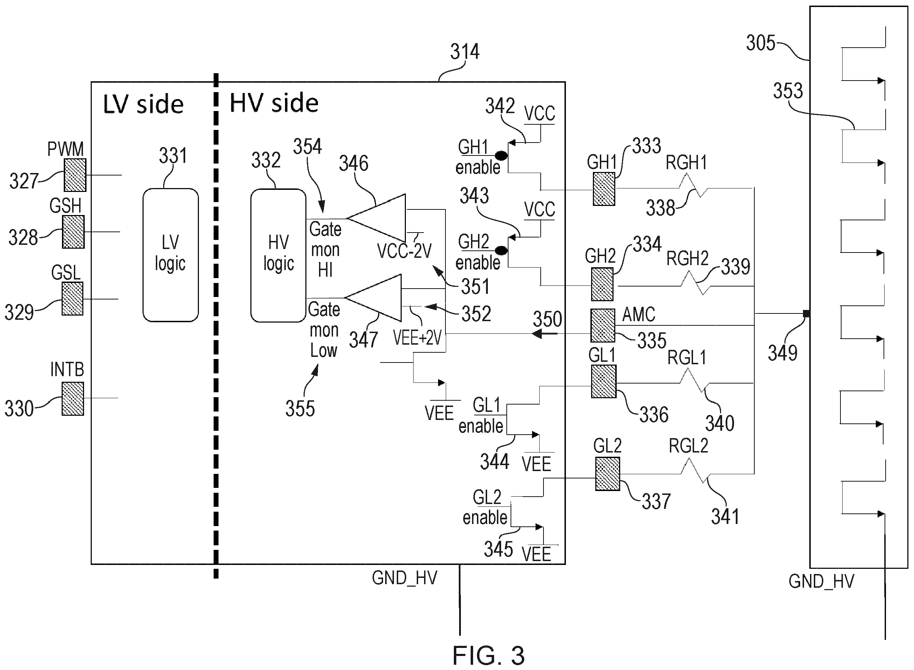

Figure 3 shows an example embodiment of a gate driver circuit 314 for driving the gate 349 of a FET 305, as one example of a power device. As indicated above, in other examples different power devices can be used. The gate driver circuit 314 and the FET 305 can be any of the gate driver circuits and FETs that are shown in Figure 1. As shown schematically in Figure 3, the FET 305 is implemented as a plurality (six in Figure 3) of paralleled-FETs 353 in this example. In an application that uses silicon carbide, twelve paralleled-FETs can be used.

It will also be appreciated that the gate driver circuit 314 and the FET 305 that are shown in Figure 3 can be provided as part of a single-phase inverter circuit. That is, it is not essential that the gate driver circuits that are disclosed herein are used with a three-phase motor as part of a three-phase inverter circuit (as shown in Figure 1).

The gate driver circuit 314 in this example is provided as an integrated circuit (IC), which has four input terminals and five output terminals shown in the drawing.

The input terminals are:
- A PWM terminal 327, which receives a signal that indicates the timing at which the FET 305 should be switched off and switched off in order to provide the required PWM control. For the circuit of Figure 1, the signal received at the PWM terminal 327 is the primary motor control signal for generating one of the 3 phase currents that are used to spin the motor.
- A GSH terminal 328, which receives a signal that sets the strength of the gate signal that is used to switch the FET 305 on (rising edges of the gate 349). Further details are provided below.
- A GSL terminal 329, which receives a signal that sets the strength of the gate signal that is used to switch the FET 305 off (falling edges of the gate 349). Further details are provided below.
- A gate monitoring terminal (AMC) 335, which is connected to the gate 349 of the FET 305 such that a gate voltage signal 350 is received at the gate monitoring terminal 335. The gate voltage signal 350 indicates the level of the voltage at the gate 349 of the FET 350. The gate monitoring terminal 335 is labelled as AMC in the drawing, which stands for active Miller clamp. More generally, as will be discussed below, this terminal can provide a connection to the input of a comparator in the gate driver circuit 314 such that it is tied directly to the gate of the external power device (in this example the FET 305) with no series resistance.

The output terminals are:
- a first gate driving high terminal (GH1) 333, which is used for providing a high-strength positive driving signal to the gate 349 of the FET 305 (i.e., for switching the FET 305 on with a high current driving signal).
- a second gate driving high terminal (GH2) 334, which is used for providing a low-strength positive driving signal to the gate 349 of the FET 305 (i.e., for switching the FET 305 on with a low current driving signal).
- a first gate driving low terminal (GL1) 336, which is used for providing a high-strength negative driving signal to the gate 349 of the FET 305 (i.e., for switching the FET 305 off with a high current driving signal to achieve a faster switching time, which generally results in less switching losses).
- a second gate driving low terminal (GL2) 337, which is used for providing a low-strength negative driving signal to the gate 349 of the FET 305 (i.e., for switching the FET 305 off with a low current driving signal to achieve slower switching, which generally results in increased switching losses but also can be an effective means of suppressing overstress on the power device when an associated motor is switching abnormally high current).
- an output terminal (INTB) 330, which provides an output signal. As will be discussed below, the output signal can be indicative of a fault associated with the FET 305, such as one of the individual paralleled-FETs 353 becoming disconnected or failing.

The FET 305 in this example can be switched on or off in one of the following four different ways.
1. The FET 305 is switched off by a high-strength negative driving signal (in accordance with an associated signal received at the GSL terminal 329). This high-strength negative driving signal is provided to the gate 349 by the first gate driving low terminal (GL1) 336. The high-strength negative driving signal is provided by closing a GL1 enable switch 344 within the gate driving circuit 314. When the GL1 enable switch 344 is closed, the first gate driving low terminal (GL1) 336 is connected to a negative voltage supply (VEE). A first gate driving low resistor (RGL1) 340 is connected in series between the first gate driving low terminal (GL1) 336 and the gate 349 of the FET 305 such that the current level of the driving signal that is provided to the gate 349 of the FET has a required value.
2. The FET 305 is switched off by a low-strength negative driving signal (in accordance with an associated signal received at the GSL terminal 329). This low-strength negative driving signal is provided to the gate 349 by the second gate driving low terminal (GL2) 337. The low-strength negative driving signal is provided by closing a GL2 enable switch 345 within the gate driving circuit 314. When the GL2 enable switch 345 is closed, the second gate driving low terminal (GL2) 337 is connected to the negative voltage supply (VEE). A second gate driving low resistor (RGL2) 341 is connected in series between the second gate driving low terminal (GL2) 337 and the gate 349 of the FET 305 such that the current level of the driving signal that is provided to the gate 349 of the FET 305 has a required value. More particularly, in this example the first gate driving low resistor (RGL1) 340 has a lower value than the second gate driving low resistor (RGL2) 341. In this way, the current level of the driving signal that is provided to the gate 349 of the FET 305 by the first gate driving low terminal (GL1) 336 is higher than the current level of the driving signal that is provided by the second gate driving low terminal (GL2) 337.
3. The FET 305 is switched on by a high-strength positive driving signal (in accordance with an associated signal received at the GSH terminal 328). This high-strength positive driving signal is provided to the gate 349 by the first gate driving high terminal (GH1) 333. The high-strength positive driving signal is provided by closing a GH1 enable switch 342 within the gate driving circuit 314. When the GH1 enable switch 342 is closed, the first gate driving high terminal (GH1) 333 is connected to a positive voltage supply (VCC). A first gate driving high resistor (RGH1) 338 is connected in series between the first gate driving high terminal (GH1) 333 and the gate 349 of the FET 305 such that the current level of the driving signal that is provided to the gate 349 of the FET has a required value.
4. The FET 305 is switched on by a low-strength positive driving signal (in accordance with an associated signal received at the GSH terminal 328). This low-strength positive driving signal is provided to the gate 349 by the second gate driving high terminal (GH2) 334. The low-strength positive driving signal is provided by closing a GH2 enable switch 343 within the gate driving circuit 314. When the GH2 enable switch 343 is closed, the second gate driving high terminal (GH2) 337 is connected to the positive voltage supply (VCC). A second gate driving high resistor (RGH2) 339 is connected in series between the second gate driving high terminal (GH2) 334 and the gate 349 of the FET 305 such that the current level of the driving signal that is provided to the gate 349 of the FET 305 has a required value. More particularly, in this example the first gate driving high resistor (RGH1) 338 has a lower value than the second gate driving high resistor (RGH2) 339. In this way, the current level of the driving signal that is provided to the gate 349 of the FET by the first gate driving high terminal (GH1) 333 is higher than the current level of the driving signal that is provided by the second gate driving high terminal (GH2) 334.

As discussed above, separate pull-up resistors (first gate driving high resistor (RGH1) 338 and second gate driving high resistor (RGH2) 339) and separate pull-down resistors (first gate driving low resistor (RGL1) 340 and second gate driving low resistor (RGL2) 341) are used to be able to provide gate driving signals with different strengths. However, in other examples variable gate driving signals may not be required such that the gate driving circuit can include a single gate driving high terminal and a single gate driving low terminal. In which case, only one pull-up resistor and one pull-down resistor can be required.

The operation of the internal switches (GH1 enable switch 342, GH2 enable switch 343, GL1 enable switch 344, and GL2 enable switch 345) that is described above can be controlled by a controller of the gate driving circuit 314. A low voltage logic module 331 and a high voltage logic module 332 of such a controller are schematically illustrated in Figure 3.

It will be appreciated from the above description that when the FET 305 is to be switched on (having previously been switched off), the voltage at the gate 349 of the FET 305 transitions from a negative value to a positive value. Similarly, when the FET 305 is to be switched off (having previously been switched on), the voltage at the gate 349 of the FET 305 transitions from a positive value to a negative value. More generally this can be considered as transitioning between a high state (VCC) and a low state (VEE), in either direction.

As shown in Figure 3, the source of the power device is connected to a ground terminal (GND_HV), which is the same ground terminal (GND_HV) to which the gate driving circuit 314 is connected. The positive voltage supply (VCC) can be set as +10V to +20V with respect to the ground terminal (GND_HV), for example. The negative voltage supply (VEE) can be set as 0V to -10V with respect to the ground terminal (GND_HV) - that is, it can be at the same voltage as the ground terminal (GND_HV) or a lower voltage than the ground terminal (GND_HV).

The gate driver circuit 314 of Figure 3 also includes a first comparator 347 and a second comparator 346. The first comparator 347 compares the gate voltage signal 350 (received at the gate monitoring terminal 335) with a first threshold value 352 to provide a first gate monitor signal (Gate mon Low) 355. The second comparator 346 compares the gate voltage signal 350 with a second threshold value 351 to provide a second gate monitor signal (Gate mon Hi) 354. The second threshold value 351 is different to the first threshold value 352. In this example, the first threshold value 352 is a positive threshold value and the second threshold value 351 is a negative threshold value. In which case, the first gate monitor signal (Gate mon Low) 355 can be referred to as a gate monitor low signal and the second gate monitor signal (Gate mon Hi) 354 can be referred to as a gate monitor high signal. The positive threshold value can be set at a voltage that is a predetermined amount less than the voltage level of the positive voltage supply (VCC). In Figure 3, the positive threshold value is set at VCC-2V. The negative threshold value can be set at a voltage that is a predetermined amount greater than the voltage level of the negative voltage supply (VEE). In Figure 3, the negative threshold value is set at VEE+2V. It will be appreciated from the description that follows that the first and second threshold values can take any (different) values that are within the range bounded by the voltage levels of the positive and negative voltage supplies (VCC and VEE), although there can be advantages to there being a relatively large difference between the threshold values so that potentially a more precise determination of the rate of change of the gate voltage (slew rate) can be determined.

As identified above, the gate driver circuit 314 includes a controller. The controller determines a gate slew rate based on the period of time between the first gate monitor signal (Gate mon Low) 355 and the second gate monitor signal (Gate mon Hi) 354 changing value for a transition in the gate voltage signal 350. This will be discussed in detail below.

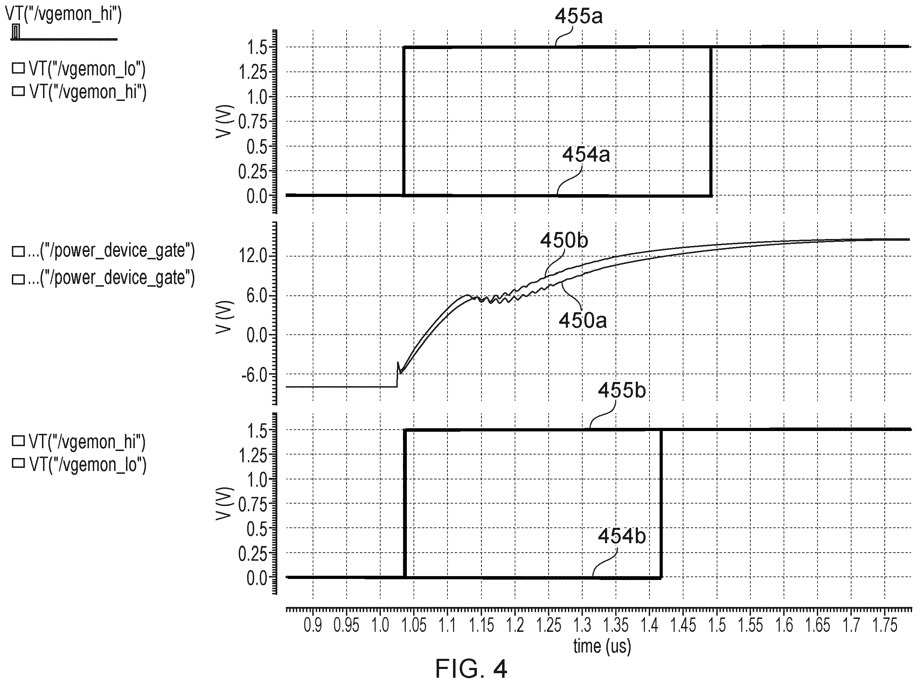

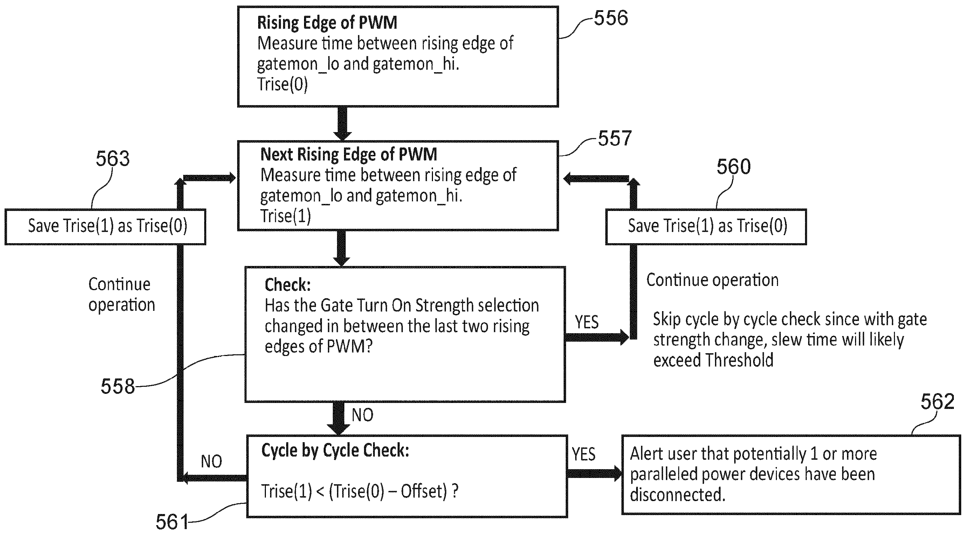

Figure 4 shows some example timing diagrams for the gate driver circuit of Figure 3.

The middle timing diagram in Figure 4 shows a plot of gate voltage signal versus time. Operation of the gate driver circuit when it is driving six paralleled-FETs is shown with reference 450a. Operation of the gate driver circuit when it is driving five paralleled-FETs (for instance because one of the six paralleled-FETs has become disconnected) is shown with reference 450b. It can be seen from Figure 4 that when the paralleled-FETs are switched on (at about 1.025 µs) the gate voltage signals 450a, 450b start to increase.

The upper timing diagram in Figure 4 shows plots of the first gate monitor signal (Gate mon Low) 455a and the second gate monitor signal (Gate mon Hi) 454a versus time, for operation of the gate driver circuit when it is driving six paralleled-FETs. That is, it corresponds to the operation that is represented by plot 450a in the middle timing diagram. It can be seen that the second gate monitor signal (Gate mon Hi) 454a changes from low to high at about 1.03 µs, which is when the corresponding gate voltage signal 450a increases above the second threshold value. The first gate monitor signal (Gate mon Low) 455a changes from low to high at about 1.49 µs, which is when the corresponding gate voltage signal 450a increases above the first threshold value.

The period of time between the first gate monitor signal (Gate mon Low) 455a and the second gate monitor signal (Gate mon Hi) 454a changing from a low value to a high value represents the slew rate (i.e. the rate of change) of the voltage at the gate of the paralleled-FETs. For the upper timing diagram, when the gate driver circuit is driving six paralleled-FETs, the slew rate as it is represented in Figure 4 is about 0.46 µs.

The lower timing diagram in Figure 4 shows plots of the first gate monitor signal (gate mon lo 455b) and the second gate monitor signal (gate mon hi 454b) versus time, for operation of the gate driver circuit when it is driving five paralleled-FETs. That is, it corresponds to the operation that is represented by plot 450b in the middle timing diagram. It can be seen that the first gate monitor signal (Gate mon Low) 455b changes from low to high at about 1.03 µs, which is when the corresponding gate voltage signal 450b increases above the second threshold value. The second gate monitor signal (Gate mon Hi) 454b changes from low to high at about 1.41 µs, which is when the corresponding gate voltage signal 450b increases above the first threshold value.

For the lower timing diagram, when the gate driver circuit is driving five paralleled-FETs, the slew rate as it is represented in Figure 4 is about 0.38 µs.

Therefore, the difference between the determined slew rates for operation with five and six paralleled-FETs is about 80ns. In an application that uses a 100 MHz clock, this difference represents about 8 clock cycles and therefore is readily discernible.

Returning to Figure 3, the controller compares the gate slew rate (e.g.: 0.46 µs if the gate driver circuit is driving six FETs 353; or 0.38 µs if the gate driver circuit is driving five FETs 353) with a slew rate threshold. Various different examples of how the slew rate threshold can be implemented will be described below. The controller can then provide an output signal, to the output terminal 330, based on the result of the comparison between the gate slew rate with the slew rate threshold.

In some examples, the controller can provide an output signal that is indicative of a fault if the difference between the gate slew rate and the slew rate threshold is greater than a predetermined level (as evidenced by the timing diagrams of Figure 4).

Figure 5 shows a method of operating a gate driver circuit according to an example embodiment of the present disclosure. The method of Figure 5 particularly relates to a method of determining a fault associated with one of a plurality of paralleled-FETs. It is recalled that the timing diagrams of Figure 3 illustrate how the slew rate in the gate voltage signal changes when one of the paralleled-FETs becomes faulty or disconnected.

At step 556, the method measures the time between the rising edge of the first gate monitor signal (Gate mon Low) and the second gate monitor signal (Gate mon Hi). This is for a rising edge of the gate voltage signal, which is for turning on the FET for PWM control in this example. This measured time, which is also referred to as slew rate in this document, is for the first rising edge and is stored as Trise(0). Trise(0) can be measured by logic counting the time it takes to drive the gate high and storing the value for each cycle, for example in a register.

At step 557, for the next rising edge of the gate voltage signal, the method measures the time between the rising edge of the first gate monitor signal (Gate mon Low) and the second gate monitor signal (Gate mon Hi). This measured time is for the second rising edge and stored as Trise(1). Trise(1) can also be stored in a register, for example.

At step 558, the method determines whether or not there has been a change to the gate turn on strength selection between the last two rising edges in the gate voltage signal / PWM signal. Such a change can be identified by a change in the signal provided to the GSH terminal that is shown in Figure 3.

If there has been a change in the gate turn on strength selection, then it is not appropriate to continue to perform a cycle by cycle check at step 561 (as will be discussed below) because the slew rate will be expected to change between the cycles due to the change in turn on strength. That is, any difference between the measured times cannot be attributed to a fault associated with the paralleled-FETs. Therefore, the method moves to step 560 thereby skipping the cycle by cycle check that will be described below with reference to step 561. At step 560, Trise(1) is saved as Trise(0) such that the method is ready to process the next rising edge of the gate voltage signal, and the method returns to step 557.

If step 558 determines that there has not been a change in the gate turn on strength selection, then the method moves on to step 561 to perform a cycle by cycle check. This involves comparing Trise(1) with a slew rate threshold. In this example, the slew rate threshold is: the determined gate slew rate for the immediately previous transition (Trise(0)) minus an offset. By rearranging the expression that is shown in Figure 5, the cycle by cycle check can also be expressed as: Is Trise(0) - Trise(1) > Offset ?

In this way, the cycle by cycle check can effectively calculate the difference between Trise(0) and Trise (1) and compare the difference with an offset. For the timing diagrams that are shown in Figure 3, an offset of 50ns can be applied such that a fault associated with a single one of the FETs can be identified.

If Trise(1) is less than the threshold (i.e., less than Trise(0) - Offset), then the method moves on to step 562 to provide an output signal that alerts a user that potentially one or more of the paralleled-FETs has been disconnected or is faulty.

If Trise(1) is not less than the threshold, then the method moves on to step 563 on the basis that no faults have been identified and operation can continue as normal. At step 563, in the same way as step 560, Trise(1) is saved as Trise(0) such that the method is ready to process the next rising edge of the gate voltage signal, and the method returns to step 557. In this way, the determined gate slew rate (Trise(1)) is stored in memory for use as (at least a component of) a slew rate threshold for a future transition in the gate voltage signal.

Therefore, if on a particular PWM cycle the slew rate has changed by more than a prescribed amount, the user can be alerted by the gate driver providing an associated output signal (for example on the output terminal (INTB) shown in Figure 3 or by any other means), that indicates that one or more of the parallel devices have potentially been disconnected.

The method that is shown in Figure 5 determines the gate slew rate based on the period of time between the first gate monitor signal and the second gate monitor signal changing value for a positive transition in the gate voltage signal. However, it will be appreciated that a corresponding method can be performed by any of the gate driver circuits disclosed herein for a negative transition in the gate voltage signal (i.e. a falling edge).

The method that is illustrated in Figure 5 can apply a gate slew rate threshold that is based on a determined gate slew rate for a previous transition in the gate voltage signal, in this example the determined gate slew rate for the immediately previous transition in the gate voltage signal. The gate slew rate threshold can comprise: a determined gate slew rate for a previous transition in the gate voltage signal plus or minus an offset value. Any environmental changes (such as temperature changes) that could affect the gate slew rate can change much slower than the frequency of the PWM control, and therefore comparing the gate slew rate for a current PWM cycle with a relatively recent earlier PWM cycle can avoid any environmental changes being falsely identified as a fault associated with a paralleled FET.

In the example of Figure 5, gate slew rate threshold comprises: a determined gate slew rate for a previous transition in the gate voltage signal minus an offset value, although it will be appreciated that in other implementations it can be appropriate to alternatively or additionally use a gate slew rate threshold for which an offset value is added to the determined gate slew rate for a previous transition in the gate voltage signal.

Furthermore, due to the check that is performed at step 558 (based on a drive strength signal that represents a requested drive strength for the gate of the FET), the gate slew rate threshold is based on a determined gate slew rate for the immediately previous transition in the gate voltage signal only if the immediately previous transition in the gate voltage signal was for operation with the same value of the requested drive strength. In this way, the gate slew rate threshold is based on a determined gate slew rate for a previous transition in the gate voltage signal for the same value of the requested drive strength.

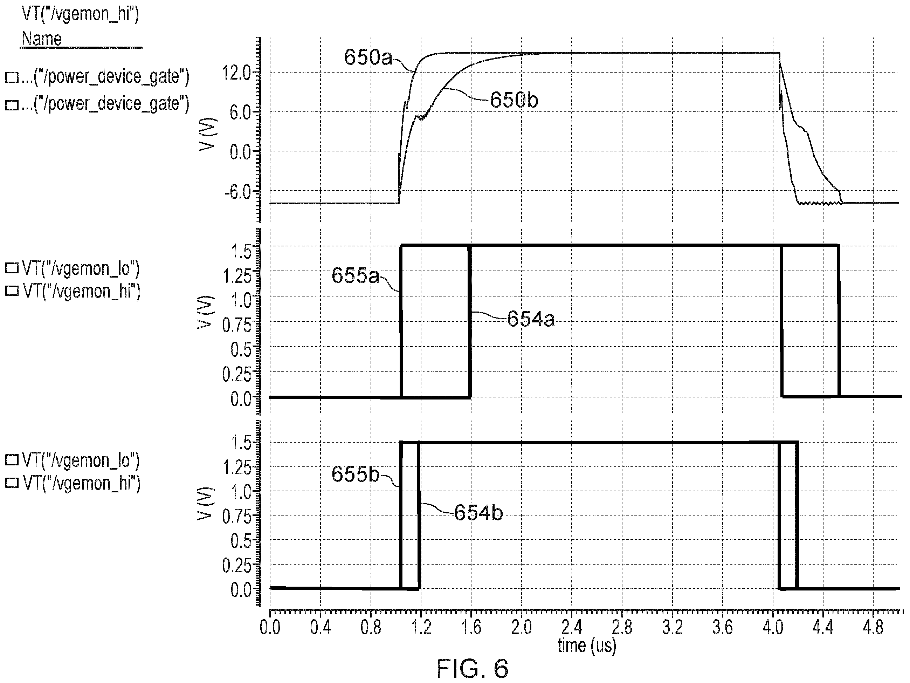

Figure 6 shows some additional example timing diagrams for the gate driver circuit of Figure 3.

The upper timing diagram in Figure 6 shows a plot of gate voltage signal versus time. Operation of the gate driver circuit when it is providing low-strength / weak driving signals to the FET is shown with reference 650b. Operation of the gate driver circuit when it is providing high-strength driving signals to the FET is shown with reference 650a. Such operation can be implemented by the gate driver circuit of Figure 3 being used with: a first gate driving high resistor and a first gate driving high resistor having a resistance value of 1 ohm; and a second gate driving high resistor and a second gate driving high resistor having a resistance value of 5 ohm, for example.

The middle timing diagram in Figure 6 shows plots of the first gate monitor signal (Gate mon low) 655a and the second gate monitor signal (Gate mon Hi) 654a versus time, for operation of the gate driver circuit when it is providing low-strength driving signals to the FET. That is, it corresponds to the operation that is represented by plot 650b in the upper timing diagram. It can be seen that the slew rate for the rising edge in the gate voltage signal (when the FET is being switched on) is about 653 ns, and that the slew rate for the falling edge in the gate voltage signal (when the FET is being switched off) is about 460 ns.

The lower timing diagram in Figure 6 shows plots of the first gate monitor signal (Gate mon lo) 655b and the second gate monitor signal (Gate mon hi) 654b versus time, for operation of the gate driver circuit when it is providing high-strength driving signals to the FET. That is, it corresponds to the operation that is represented by plot 650a in the upper timing diagram. It can be seen that the slew rate for the rising edge in the gate voltage signal (when the FET is being switched on) is about 145 ns, and that the slew rate for the falling edge in the gate voltage signal (when the FET is being switched off) is about 121ns.

Therefore, the difference between the determined slew rates for operation with high-strength and low-strength driving signals can be readily discernible in a system that uses a 100 MHz clock.

In some examples, the controller of the gate driver circuit of Figure 3 can provide an output signal that is indicative of an incorrect drive strength being applied to the FET 305 (as evidenced by the timing diagrams of Figure 6). That is, the controller can receive a drive strength signal that represents a requested drive strength for the gate of the FET (for instance, as is provided at the GSH terminal 328 and / or the GSL terminal 329). The controller can then set the slew rate threshold as one of a plurality of predetermined values based on the received drive strength signal. By way of non-limiting example, for the timing diagrams that are shown in Figure 6 the controller can then set the slew rate threshold based on:
- 553 ns for a rising edge transition in the gate voltage signal for a low-strength positive driving signal;
- 460 ns for a falling edge transition in the gate voltage signal for a low-strength negative driving signal;
- 145 ns for a rising edge transition in the gate voltage signal for a high-strength positive driving signal; and
- 121 ns for a falling edge transition in the gate voltage signal for a high-strength negative driving signal.

The controller can provide an output signal that is indicative of a incorrect operation if the difference between the gate slew rate and the slew rate threshold is greater than a predetermined offset value that is suitable for discerning between operation with different strength driving signals. The predetermined offset value may be 50 ns, 100 ns or 200 ns, for example, although the appropriate level to use will be dictated by the relative differences between the high-strength and low-strength driving signals. In this way, the gate slew rate threshold can comprise: a predetermined gate slew rate for the requested drive strength plus or minus an offset value.

Therefore, if a user commands weak drive signals for the gate of the FET yet the gate driver circuit of Figure 3 measures a slew rate of ~145ns (or any other value that does not satisfy the slew rate threshold) for a rising edge of the gate voltage signal, the controller can provide an output signal that causes an alert to be sent that signals that an incorrect drive strength is potentially being applied to the FET.

Such examples are particularly well-suited to advanced gate drivers that can provide multiple drive strengths to a switching power device (e.g. a FET). A weak drive strength might be deployed for cases where the load current is excessively high or the temperature excessively low, to suppress unwanted voltage spikes. In such applications, it can be beneficial for a user to receive verification that the correct gate strength has been applied to the power device.

Otherwise, in cases where light drive strength is commanded, but high drive strength is applied, over multiple switching cycles, damage can occur to the power device / system.

If a fault such as an open gate wire bond occurs in between drive cycles, when power is off, then the cycle by cycle check of Figure 5 will not be able to detect the fault / disconnection. However, for an inverter circuit that includes a plurality of gate driver circuits for respective ones of a plurality of FETs (for instance a three-phase inverter has six gate driver circuits; and a single-phase inverter has two gate driver circuits), a gate driver circuit can apply a slew rate threshold that is based on a determined gate slew rate for another of the gate driver circuits. That is, the determined gate slew rates for the plurality of gate driver circuits can be compared with each other such that a fault can be identified if there is a significant difference (e.g. one that is greater than a predetermined offset) between them. In this way, the slew rate threshold for each of the gate driver circuits can be based on a determined gate slew rate for one or more of the other gate driver circuits.

As discussed above, a single leg / phase of an inverter circuit can include: a high-side FET; a low-side FET; a high-side gate driver circuit for driving the gate of the high-side FET; and a low-side gate driver circuit for driving the gate of the low-side FET. In such an example, the slew rate threshold for the high-side gate driver circuit can be based on a determined gate slew rate for the low-side gate driver circuit; and / or the slew rate threshold for the low-side gate driver circuit can be based on a determined gate slew rate for the high-side gate driver circuit.

This functionality can be implemented by providing a readable register that stores at least the most recent value for the determined gate slew times for each of the gate driver circuits. The gate driver circuit can then toggle the gate each of each FET on and off at power up and read back the slew up/down times of each of the branches of the inverter. At this time, the controller of one or more of the date driver circuits can determine if the slew rate for one or more of the branches are not the same as the others, such that a fault can be indicated by generating an associated output signal.

Additionally or alternatively, at power up the gate driver circuits can toggle the gates with all the drive strength selections available in the gate driver circuit. Then, the gate driver circuits can also check that strong vs weak drive strength generate the expected difference in slew times such that there is confidence that the correct drive strength is being applied to gate.

With reference to the timing diagram of Figure 2, it is recalled that there can be advantages to having a deadtime in between a high-side FET being switched on the associated low-side FET being switched off (and *vice versa*). It is also recalled that it is generally desired to have at least a minimum value of the deadtime 226. However, if the deadtime is unnecessarily long then the performance of an associated inverter circuit can be degraded. As will be discussed below, advantageously a gate driver circuit of the present disclosure can be configured such that it reads the falling edge slew times of the gate of one of the FETs, compares this time with a threshold that represents one or more target deadtimes, and then determines if a reduction in the deadtime is possible or if the deadtime should be increased to reduce the likelihood of unwanted shoot through currents.

Referring now to Figure 1, the inverter circuit includes three high-side gate driver circuits 114, 116, 118 and three low-side gate driver circuits 115, 117, 119. Each of these gate driver circuits is implemented as shown in Figure 3.

The controllers of the high-side gate driver circuits 114, 116, 118 and / or the low-side gate driver circuits 115, 117, 119 can determine the gate slew rate based on the period of time between the first gate monitor signal and the second gate monitor signal changing value for a negative transition in the gate voltage signal for its associated FET (that is, when the FET is switched off). The controllers can then provide an output signal to the other one of the high-side gate driver circuit and / or the low-side gate driver circuit in the same leg. The output signal is based on the result of the comparison of the gate slew rate with a slew rate threshold. Also, the output signal is for setting a time at which the FET associated with the other one of the high-side gate driver circuit and / or the low-side gate driver circuit is switched on. Use of such a single slew rate threshold can ensure that the FET associated with the other gate driver circuit in the same leg of the inverter circuit is not switched on either too soon or too late (as defined by the value of the threshold).

In a further example, one or two slew rate thresholds can be used to ensure that the FET associated with the other gate driver circuit in the same leg of the inverter circuit is not switched on too soon and / or to ensure that it is not switched on too late. In such an example, the controller can compare the gate slew rate at turn off with the deadtime the controller is applying between the high side and low side power switch. That is, the deadtime that the controller is applying can be used a slew rate threshold. If the measured turn off slew rate is longer than the applied deadtime, the controller could increase the applied deadtime to avoid the potential for shoot thru current. If the measured slew rate is shorter than the applied deadtime, the controller may continue with the same applied deadtime. Alternatively, in this case, the controller could decrease the applied deadtime, which could bring an improvement in motor performance. For instance, the controller can compare the gate slew rate with a slew rate first threshold (which has a value that is based on the deadtime that is applied by the controller). If the gate slew rate is greater than the slew rate first threshold, then the controller can increase the deadtime that it will apply for future switching operations. Also, the controller can compare the gate slew rate with a slew rate second threshold. The slew rate second threshold can also have a value that is based on the deadtime that is applied by the controller - i.e., it can have the same value as the deadtime that is applied by the controller (which in some implementations can be the same as the slew rate first threshold), or it can have a value that is less than the deadtime that is applied by the controller (which again can be the less than the slew rate first threshold) by a predetermined amount in order to provide hysteresis in the control of the deadtime that is applied by the controller.

Examples disclosed herein are particularly useful when a power device (e.g. a FET) is made up of multiple devices connected in parallel (e.g. paralleled FETs). Such examples can perform a method that verifies all the gates of all devices are properly connected to a gate driver circuit. A missing device could result in extra heating and potential reliability issue in the power device. Additionally, in applications where an advanced gate driver can apply a variable drive strength to the power device, methods disclosed herein can be used to verify that the appropriate drive strength is applied.

The present disclosure describes a device that measures the time between a gate slewing up from negative to positive rail at turn on and *vice versa* at turn off. The time can be stored and constantly compared to previous times to determine if either:
- the power device has lost some of its paralleled-FETs, which is seen as a reduced load capacitance to the gate driver; or
- for an advanced gate driver that has the ability to provide strong/weak drive, the device for whatever reason, is providing the incorrect drive strength.

This functionality enables the health of a power device to be monitored and also enables a determination that the correct drive strength is being provided.

Examples of a gate driver circuit that are disclosed herein can constantly monitor the slew rate of a power device gate and compare it to a previous cycle. This can provide a method to immediately detect if a paralleled power device may have 1 or more of its devices faulted. This is easily done by setting an offset / threshold for delta time between successive PWM cycles. If the time difference between two adjacent PWM edges is longer than this predetermined offset / threshold, then the gate driver circuit can alert a user that the inverter is operating without all of its intended power devices.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A gate driver circuit for driving the gate of a power device, wherein the gate driver circuit comprises:
a gate monitoring terminal, which is connectable to the gate of the power device such that a gate voltage signal is receivable at the gate monitoring terminal;
a first comparator configured to compare the gate voltage signal with a first threshold value to provide a first gate monitor signal;
a second comparator configured to compare the gate voltage signal with a second threshold value, which is different to the first threshold value, to provide a second gate monitor signal;
a controller configured to:
determine a gate slew rate based on the period of time between the first gate monitor signal and the second gate monitor signal changing value for a transition in the gate voltage signal;
compare the gate slew rate with a slew rate threshold; and
provide an output signal based on the result of the comparison between the gate slew rate with the slew rate threshold.

2. The gate driver circuit of claim 1, wherein:
the first comparator is configured to compare the gate voltage signal with a negative threshold value to provide a gate monitor low signal; and
the second comparator configured to compare the gate voltage signal with a positive threshold value to provide a gate monitor high signal.

3. The gate driver circuit of claim 1 or claim 2, wherein the controller is configured to:
provide an output signal that is indicative of a fault if the difference between the gate slew rate and the slew rate threshold is greater than a predetermined level.

4. The gate driver circuit of any preceding claim, wherein:
the gate slew rate threshold is based on a determined gate slew rate for a previous transition in the gate voltage signal.

5. The gate driver circuit of claim 4, wherein:
the slew rate threshold is based on a determined gate slew rate for the immediately previous transition in the gate voltage signal.

6. The gate driver circuit of claim 4 or claim 5, wherein:
the gate slew rate threshold is based on: a determined gate slew rate for a previous transition in the gate voltage signal plus or minus an offset value.

7. The gate driver circuit of any preceding claim, wherein:
the controller is configured to receive a drive strength signal that represents a requested drive strength for the gate of the power device; and
the gate slew rate threshold is based on a determined gate slew rate for a previous transition in the gate voltage signal for the same value of the requested drive strength.

8. The gate driver circuit of any one of claims 1 to 3, wherein the controller is configured to:
receive a drive strength signal that represents a requested drive strength for the gate of the power device; and
set the slew rate threshold as one of a plurality of predetermined values based on the received drive strength signal.

9. The gate driver circuit of claim 8, wherein:
the gate slew rate threshold is based on: a predetermined gate slew rate for the requested drive strength plus or minus an offset value.

10. The gate driver circuit of any preceding claim, wherein the controller is configured to:
determine the gate slew rate based on the period of time between the first gate monitor signal and the second gate monitor signal changing value for a positive transition in the gate voltage signal.

11. The gate driver circuit of any preceding claim, wherein the controller is configured to:
determine the gate slew rate based on the period of time between the first gate monitor signal and the second gate monitor signal changing value for a negative transition in the gate voltage signal.

12. The gate driver circuit of any preceding claim, wherein the power device comprises a plurality of paralleled-power devices.

13. An inverter circuit comprising:
a motor that is operable in accordance with a control signal;
a high-side power device having a conduction channel that is connected in series between a positive voltage supply and a control signal terminal;
a low-side power device having a conduction channel that is connected in series between the control signal terminal and a negative voltage supply;
a high-side gate driver circuit according to any preceding claim, wherein the high-side gate driver circuit is for driving the gate of the high-side power device;
a low-side gate driver circuit according to any preceding claim, wherein the low-side gate driver circuit is for driving the gate of the low-side power device; and
wherein:
the voltage at the control signal terminal is connected to the motor in order to provide the control signal to the motor when the inverter circuit is in use;
the slew rate threshold for the high-side gate driver circuit is based on a determined gate slew rate for the low-side gate driver circuit; and / or
the slew rate threshold for the low-side gate driver circuit is based on a determined gate slew rate for the high-side gate driver circuit.

14. The inverter circuit of claim 13, wherein the controller of the high-side gate driver circuit and / or the low-side gate driver circuit is configured to:
determine the gate slew rate based on the period of time between the first gate monitor signal and the second gate monitor signal changing value for a negative transition in the gate voltage signal of the associated power device; and
provide an output signal to the other one of the high-side gate driver circuit and the low-side gate driver circuit based on the result of the comparison of the gate slew rate with the slew rate threshold, wherein the output signal is for setting a time at which the power device associated with the other one of the high-side gate driver circuit and the low-side gate driver circuit is switched on.

15. An inverter circuit comprising:
a three-phase motor that is operable in accordance with a first-phase control signal, a second-phase control signal and a third-phase control signal;
a first-phase high-side power device having a conduction channel that is connected in series between a positive voltage supply and a first-phase control signal terminal;
a first-phase low-side power device having a conduction channel that is connected in series between the first-phase control signal terminal and a negative voltage supply;
a second-phase high-side power device having a conduction channel that is connected in series between the positive voltage supply and a second-phase control signal terminal;
a second-phase low-side power device having a conduction channel that is connected in series between the second-phase control signal terminal and the negative voltage supply;
a third-phase high-side power device having a conduction channel that is connected in series between the positive voltage supply and a third-phase control signal terminal;
a third-phase low-side power device having a conduction channel that is connected in series between the third-phase control signal terminal and the negative voltage supply;
a plurality of gate driver circuits according to any one of claims 1 to 12, one for each of the six power devices, wherein the slew rate threshold for each of the gate driver circuits is based on a determined gate slew rate for one or more of the other gate driver circuits.

## Amended claims

### Amended claims in accordance with Rule 137(2) EPC.

1. A gate driver circuit (314) for driving the gate (349) of a power device (305), wherein the gate driver circuit comprises:
a gate monitoring terminal (335), which is connectable to the gate (349) of the power device (305) such that a gate voltage signal (350) is receivable at the gate monitoring terminal;
a first comparator (347) configured to compare the gate voltage signal (350) with a first threshold value to provide a first gate monitor signal (355);
a second comparator (346) configured to compare the gate voltage signal (350) with a second threshold value, which is different to the first threshold value, to provide a second gate monitor signal (354);
a controller configured to:
determine a gate slew rate based on the period of time between the first gate monitor signal (355) and the second gate monitor signal (354) changing value for a transition in the gate voltage signal (350);
compare the gate slew rate with a slew rate threshold; and
provide an output signal based on the result of the comparison between the gate slew rate with the slew rate threshold.

2. The gate driver circuit (314) of claim 1, wherein:
the first comparator (347) is configured to compare the gate voltage signal (350) with a negative threshold value to provide a gate monitor low signal; and
the second comparator (346) configured to compare the gate voltage signal (350) with a positive threshold value to provide a gate monitor high signal.

3. The gate driver circuit (314) of claim 1 or claim 2, wherein the controller is configured to:
provide an output signal that is indicative of a fault if the difference between the gate slew rate and the slew rate threshold is greater than a predetermined level.

4. The gate driver circuit (314) of any preceding claim, wherein:
the gate slew rate threshold is based on a determined gate slew rate for a previous transition in the gate voltage signal (350).

5. The gate driver circuit (314) of claim 4, wherein:
the slew rate threshold is based on a determined gate slew rate for the immediately previous transition in the gate voltage signal (350).

6. The gate driver circuit (314) of claim 4 or claim 5, wherein:
the gate slew rate threshold is based on: a determined gate slew rate for a previous transition in the gate voltage signal (350) plus or minus an offset value.

7. The gate driver circuit (314) of any preceding claim, wherein:
the controller is configured to receive a drive strength signal that represents a requested drive strength for the gate (349) of the power device (305); and
the gate slew rate threshold is based on a determined gate slew rate for a previous transition in the gate voltage signal (350) for the same value of the requested drive strength.

8. The gate driver circuit (314) of any one of claims 1 to 3, wherein the controller is configured to:
receive a drive strength signal that represents a requested drive strength for the gate (349) of the power device (305); and
set the slew rate threshold as one of a plurality of predetermined values based on the received drive strength signal.

9. The gate driver circuit (314) of claim 8, wherein:
the gate slew rate threshold is based on: a predetermined gate slew rate for the requested drive strength plus or minus an offset value.

10. The gate driver circuit (314) of any preceding claim, wherein the controller is configured to:
determine the gate slew rate based on the period of time between the first gate monitor signal (355) and the second gate monitor signal (344) changing value for a positive transition in the gate voltage signal.

11. The gate driver circuit (314) of any preceding claim, wherein the controller is configured to:
determine the gate slew rate based on the period of time between the first gate monitor signal (355) and the second gate monitor signal (354) changing value for a negative transition in the gate voltage signal.

12. The gate driver circuit (314) of any preceding claim, wherein the power device (305) comprises a plurality of paralleled-power devices (353).

13. An inverter circuit comprising:
a motor (101) that is operable in accordance with a control signal;
a high-side power device (105) having a conduction channel that is connected in series between a positive voltage supply and a control signal terminal (111);
a low-side power device (106) having a conduction channel that is connected in series between the control signal terminal (111) and a negative voltage supply;
a high-side gate driver circuit (114) according to any preceding claim, wherein the high-side gate driver circuit is for driving the gate of the high-side power device (105);
a low-side gate driver circuit (115) according to any preceding claim, wherein the low-side gate driver circuit is for driving the gate of the low-side power device (106); and
wherein:
the voltage at the control signal terminal (111) is connected to the motor (101) in order to provide the control signal to the motor when the inverter circuit is in use;
the slew rate threshold for the high-side gate driver circuit (114) is based on a determined gate slew rate for the low-side gate driver circuit (115); and / or
the slew rate threshold for the low-side gate driver circuit (115) is based on a determined gate slew rate for the high-side gate driver circuit (114).

14. The inverter circuit of claim 13, wherein the controller of the high-side gate driver circuit (114) and / or the low-side gate driver circuit (115) is configured to:
determine the gate slew rate based on the period of time between the first gate monitor signal and the second gate monitor signal changing value for a negative transition in the gate voltage signal of the associated power device; and
provide an output signal to the other one of the high-side gate driver circuit (114) and the low-side gate driver circuit (115) based on the result of the comparison of the gate slew rate with the slew rate threshold, wherein the output signal is for setting a time at which the power device associated with the other one of the high-side gate driver circuit and the low-side gate driver circuit is switched on.

15. An inverter circuit comprising:
a three-phase motor (101) that is operable in accordance with a first-phase control signal (121), a second-phase control signal (122) and a third-phase control signal (123);
a first-phase high-side power device (105) having a conduction channel that is connected in series between a positive voltage supply and a first-phase control signal terminal (111);
a first-phase low-side power device (106) having a conduction channel that is connected in series between the first-phase control signal terminal (111) and a negative voltage supply;
a second-phase high-side power device (107) having a conduction channel that is connected in series between the positive voltage supply and a second-phase control signal terminal (112);
a second-phase low-side power device (108) having a conduction channel that is connected in series between the second-phase control signal terminal (112) and the negative voltage supply;
a third-phase high-side power device (109) having a conduction channel that is connected in series between the positive voltage supply and a third-phase control signal terminal (113);
a third-phase low-side power device (110) having a conduction channel that is connected in series between the third-phase control signal terminal (113) and the negative voltage supply;
a plurality of gate driver circuits (114, 115, 116, 117, 118, 119) according to any one of claims 1 to 12, one for each of the six power devices (105, 106, 107, 108, 109, 110), wherein the slew rate threshold for each of the gate driver circuits is based on a determined gate slew rate for one or more of the other gate driver circuits.
